# EUROPEAN PATENT SPECIFICATION

(11) **EP 4 040 172 B1**
(45) Date of publication and mention of the grant of the patent: **28.08.2024**
(21) Application number: 21155820.0
(22) Date of filing: 08.02.2021
(51) Int. Cl.: G01R 31/12, H01H 9/50, H02H 1/00

(54) **ARC FAULT DETECTION CIRCUIT AND METHOD FOR DETECTING AN ARC FAULT**
LICHTBOGENFEHLERDETEKTIONSSCHALTUNG UND VERFAHREN ZUR DETEKTION EINES LICHTBOGENFEHLERS
CIRCUIT DE DÉTECTION DE DÉFAUT D'ARC ET PROCÉDÉ DE DÉTECTION DE DÉFAUT D'ARC

(43) Date of publication of application: 10.08.2022
(73) Proprietor: ABB Schweiz AG, 5400 Baden (CH)
(72) Inventor: Varga, Matija, 8006 Zurich (CH); Maret, Yannick, 5405 Dättwil (CH); Butti, Agostino, 20151 Milano (IT); Ghezzi, Luca, 21013 Gallarate (IT)
(74) Representative: Sykora & König Patentanwälte PartG mbB

(56) References cited:
- EP-A1- 2 706 636
- EP-A1- 3 015 872
- US-B1- 9 897 642

## Description

### FIELD OF THE INVENTION

The invention relates to the field of arc fault detection. In particular, the invention relates to an arc fault detection circuit for detecting an arc fault in an electric line and to a method for detecting an arc fault in an electric line.

### BACKGROUND OF THE INVENTION

An electrical network may comprise different electrical devices, i.e. loads. Detection of an arc fault in such an electrical network is crucial for preventing fires caused by electricity. An arc fault may generate a characteristic signal across a wide range of frequencies (e.g. 1 Hz to 1 GHz, e.g. 10 Hz to 20 MHz). However, the loads may generate signals that may mask an arc fault signal and consequently result in false alarms or missed arc fault events.

The main challenge of an arc-fault detector is to determine whether the measured signal is arising from an arc or a load. If there is a load or a combination of loads that have signal features like those of an arc fault, a false alarm may be triggered. Another scenario that may lead to misclassifications of arc faults is a corruption of a frequency channel. For example, a strong interference can mask an arc fault signal and make a specific frequency channel unusable.

An arc fault detection device may use a zero-crossing detector for determining the presence of certain frequencies in the measured signal.

EP 3 386 051 A1 describes such an electronic protection device for a LV (Low Voltage) electric line including one or more conductors, comprising: one or more pairs of electric contacts adapted to be electrically connected with corresponding conductors of said electric line, said electric contacts being operatively couplable or decouplable one from another; a control unit adapted to control the operation of said electronic protection device, wherein said control unit comprises an electronic arrangement to detect and determine arc fault conditions in said electric line.

EP 3 439 127 A1 describes an electronic protection device for a LV electric line, said protection device being provided with a control unit having a controller comprising a central processing unit and an arc fault determination module executable by said central processing unit and configured to implement arc detection functions to determine the presence of arc fault conditions in said electric line. The arc fault determination module is configured to process one or more input values indicative of operating conditions of said electric line to implement said arc detection functions. The controller comprises a data acquisition arrangement adapted to manage acquisition and storage of said input values.

EP 2 706 636 A1 describes electrical devices each including a noise filter to eliminate noise in an external common AC power, a plurality of loads to receive the noise-free AC power and perform predetermined functions, an arc fault detector to detect an arc fault in the plurality of loads, and a main switch to cut the external AC power to a load, upon detection of an arc fault in the load. The arc fault detector may be connected to the output end of the noise filter. The arc fault detector may detect current flowing through the plurality of loads of the electrical device based on the AC power received from the noise filter. The arc fault detector may include a current detector, a filter unit, a comparison unit, a controller, a memory, an output unit, and a driver. The current detector may detect current flowing through the plurality of loads in the electrical device. The comparison unit may compare the voltage of the frequency passed through the filter unit with a predetermined threshold voltage and output a comparison signal accordingly, wherein the comparison signal may be a high or low signal. The plurality of HPFs may have different cut-off frequencies and may pass the frequency of current detected by the current detector by dividing the frequency of the detected current into frequency bands corresponding to the cut-off frequencies, wherein the plurality of HPFs may output voltages corresponding to frequencies equal to or higher than the predetermined cut-off frequencies.

EP 3 015 872 A1 according to our present understanding seems to describe a circuit arrangement including an AC-input port for connecting an AC voltage, a band pass filter, a threshold detection circuit, a transfer circuit, a threshold detection logic and a DC supplying circuit, wherein the circuit arrangement allows an unipolar detection of threshold crossings of positive or negative half waves of the AC voltage for one single threshold level. The band pass filter comprises a first filter input terminal, a second filter input terminal and a first filter output. The threshold detection circuit comprises a first voltage input, a first reference terminal, a first DC-power supply input, a first detection output, a first comparator element, which may comprise an operational amplifier, and a first reference voltage circuit. Each comparator element may provide a hysteresis.

US 9 897 642 B1 describes a system including an inverter, an AFCI, a first subarray with 28 PV strings, a second subarray with 31 PV strings, and a third subarray with 56 PV strings, with each string having a plurality of PV modules, where different numbers of modules can be provided for each string. Filters having different cutoff frequencies can be placed within the system to identify the particular subarray, wherein a first filter is electrically connected to the 28-string subarray, a second filter to the 31-string subarray, and a third filter to the 56-string subarray. Each of these first, second, and third filters can be chosen to have differing cutoff frequencies, e.g. as in a lowpass filter, or range of cutoff frequencies, e.g. as in a bandpass filter. The system enables to deduce a subarray location of an arc-fault.

However, if another load or an interference appears in the measured frequency band, the number of zero crossings will be determined by that load/interference, rather than by an arc fault. An analog signal processing may consist of one low frequency channel (e.g. 10 Hz to 50 kHz, e.g. 50 Hz to 10 kHz) that samples the signal and one high frequency channel (e.g. 1 MHz to 50 MHz, e.g. 10 MHz to 15 MHz) that uses zero- crossing detection. However, if the high frequency channel gets corrupted/masked, the arc fault detection must be performed with only the low frequency channel. But in many cases, features of an arc fault signal do not appear in the low frequency channel or they are difficult to differentiate from features of loads.

### DESCRIPTION OF THE INVENTION

Therefore, it is an object of the present invention to provide an arc fault detection circuit, which is able to reliably detect the presence of an arc fault in an electric line of an electrical network, even if there are loads in the electrical network, which generate signals in the same or a similar frequency range as a typical arc fault.

It is another object of the present invention to provide a method for detecting an arc fault in an electric line of an electrical network, which enables to reliably detect the presence of the arc fault in the electric line, even if there are loads in or connected to the electrical network, which generate signals in the same or a similar frequency range as a typical arc fault.

These objects are achieved by the subject-matter of the independent claims. Further exemplary embodiments are evident from the dependent claims and the following description.

According to an aspect an arc fault detection circuit for detecting an arc fault in an electric line is provided. The arc fault detection circuit comprises: a filter, which has a filter input for receiving an input signal from the electric line and a filter output for outputting a filtered signal; a circuit element, which has a circuit element input for outputting a reference signal; a comparator, which has a first comparator input coupled to the filter output for receiving the filtered signal, a second comparator input coupled to the circuit element output for receiving the reference signal, and a comparator output for providing a binary output signal depending on a difference between the filtered signal and the reference signal; and an arc fault determination module, which is coupled to the comparator output and which is configured to determine the presence of the arc fault in the electric line depending on the output signals of the comparator, wherein the filter is configured such that a cutoff frequency of the filter can be changed.

The filter being configured such that the cutoff frequency of the filter can be changed enables to switch to another frequency range, e.g. if a load masking the arc fault signal generates a load signal in the same frequency range as the filter. In addition, even if there is no load masking the arc fault signal, changing the cutoff frequency of the filter may contribute to achieve a very reliable arc fault detection. Changing the properties of the filter in time corresponds to a switching between different filter configurations. This is very cost-efficient compared to an approach, according to which multiple frequency bands are simultaneously acquired by having multiple parallel branches, each consisting of a one or more filters and a comparator, e.g. a Schmitt trigger.

During operation of the arc fault detection circuit, multiple frequency bands are sensed with the reconfigurable filter and the comparator. The measured signal of the electric line may be preconditioned, e.g. by impedance matching and prefiltering, and is then branched and fed into the filter with a reconfigurable cutoff frequency. The outputs of the filter and the circuit element are then connected to the two inputs of the comparator. The comparator only toggles its output when the difference between the two inputs becomes larger than a threshold voltage. The threshold voltage may be set by an external resistor network. Thus, a frequency selectivity is achieved because the filter attenuates the voltage difference at all frequencies except around the frequency band of interest.

So, the filter being reconfigurable as outlined above enables to measure the signal of the arc fault in multiple frequency bands. If one frequency band is masked by a load, the arc fault detecting circuit may switch to a different frequency band and as such avoid the masking of the arc fault signal. So, the arc fault detection circuit is able to reliably detect the presence of the arc fault in the electric line of the electrical network, even if there are loads in the electrical network, which generate signals in the same or a similar frequency range as the arc fault. If no masking loads in or connected to the electrical network exist, the arc fault detection circuit may use the different frequency bands of the filter as additional information for the arc fault detection. In particular, instead of one signal processing channel per frequency band, there is provided only one channel, whose frequency selectivity can be changed by switching between different filter configurations. So, the arc fault determination module is supplied with at least two independent sources of information. Thus, the arc fault detection circuit is able to reliably detect the presence of the arc fault in the electric line of the electrical network, even if there are no loads in the electrical network, which generate signals in the same or a similar frequency range as the arc fault.

The arc fault determination module, or simply determination module, may correspond to one of the prior art determination modules described above. For example, the arc fault determination module may be executable by a central processing unit of an arc fault detection device or an electronic protection device and may be configured to implement arc detection functions to determine the presence of arc fault conditions in the electric line. The arc fault determination module may be configured to process one or more input values indicative of operating conditions of the electric line to implement the arc detection functions. For example, the arc fault determination module may use the zero-crossing concept of the above prior art in order to identify the arc fault in the filtered signals. In the present case, the output voltage of the Schmidt trigger may be processed to determine the arc fault using well-known features of arc-fault signals. In particular, the arc fault determination module may use information from the low-frequency channel, e.g. a variation of the peak magnitude between halfwaves or presence of shoulders around zero-crossings of the current, and information from the high-frequency channel(s), e.g. absence of noise at zero-crossings of the current, in order to determine the presence of the arc fault. The information from the channels can be used independently or combined in order to improve robustness. As a result, the present invention extends the zero-crossing concept to multiple frequency bands without adding much hardware complexity. The proposed solution is thus attractive from both cost and complexity perspectives. The disclosed solutions are in particular advantageous for adding high-frequency channels (e.g. above 10 kHz, e.g. above 1 MHz).

According to one or more embodiments, the circuit element provides a constant DC-value as the reference signal. This contributes to a simple and cost-efficient implementation of the reference signal. For example, the circuit element is a voltage reference providing a constant DC-signal as the reference signal.

According to one or more embodiments, the above filter is a first filter, the above filter input is a first filter input for receiving the input signal from the electric line, the above filter output is a first filter output, and the above filtered signal is a first filtered signal. In addition, the circuit element comprises a second filter having a second filter input for receiving the input signal from the electric line and a second filter output for outputting a second filtered signal as the reference signal. This contributes to a simple and cost-efficient implementation of the circuit element. The first and/or the second filter may be a low-pass filter, a high-pass filter, or a band-pass filter.

According to one or more embodiments, the second filter is configured such that a cutoff frequency of the second filter can be changed. This reconfigurability of second filter further increases the possibilities of the arc fault detection circuit regarding differentiating between signals of loads and arc fault signals in the electric line.

According to one or more embodiments, the filter of the two filters, from which the cutoff frequency can be changed, comprises a first filter element providing a first cutoff frequency and a second filter element providing a second cutoff frequency, and wherein the cutoff frequency provided by the corresponding filter can be changed by activating the first filter element or the second filter element. This may contribute to a very cost-efficient arc fault detection circuit.

According to one or more embodiments, the first filter element comprises a first capacitor, which has a first capacitance, and the second filter element comprises a second capacitor, which has a second capacitance different from the first capacitance. This may contribute to a very cost-efficient arc fault detection circuit having a simple structure.

According to one or more embodiments, at least one of the filters is a passive filter and/or at least one of the filters comprises an inductor and a capacitor. The capacitor of the filter may correspond to the corresponding filter element. This may contribute to a very cost-efficient arc fault detection circuit having a simple structure.

According to one or more embodiments the arc fault detection circuit further comprises a switch for activating the first filter element or the second filter element. The switch may have two-states. In each of the two states, the switch connects one of the filter elements, e.g. the corresponding capacitor, to the rest of the corresponding filter. As a result, the comparator changes its frequency selectivity, i.e. toggles its output only for input signals within a selected frequency band.

According to one or more embodiments, the switch is an analogue and/or mechanical switch. This may contribute to a very cost-efficient arc fault detection circuit having a simple structure.

According to one or more embodiments, the comparator is a comparator with hysteresis.

According to one or more embodiments, the comparator is an analogue comparator. In other words, the comparator may consist of discrete components processing analogue signals only. This may contribute to a very cost-efficient arc fault detection circuit having a simple structure.

According to one or more embodiments, the arc fault detection circuit further comprises a Schmitt-Trigger, which comprises the comparator. So, in each of the two states the switch connects one of the filter elements, e.g. the corresponding capacitor, to the rest of the corresponding filter and as a result, the Schmitt trigger changes its frequency selectivity, i.e. toggles its output only for input signals within a selected frequency band.

According to one or more embodiments, the arc fault detection circuit further comprises: a coil, which is coupled to the electric line and which serves as a sensor; an input filter, which is coupled to the electric line; a protection circuit, which is coupled to the input filter; and a filter stage, which is coupled to the protection circuit, the filter input of the filter, e.g. the first filter input of the first filter, and the circuit element input of the circuit element for providing the input signal to the corresponding filter input and the circuit element input. The filter stage may comprise one or more filters, e.g. band-pass filters and/or high-pass filters, e.g. one or more Sallen Key high-pass filters.

According to another aspect a method for detecting an arc fault in an electric line is provided. The method comprises the steps of receiving an input signal from the electric line and outputting a filtered signal, by a filter; receiving the input signal from the electric line and outputting a reference signal, by a circuit element; providing a binary output signal depending on a difference between the filtered signal and the reference signal; and determining the presence of the arc fault in the electric line depending on the output signals, wherein a cutoff frequency of the filter can be changed.

According to one or more embodiments, a constant DC-value is provided as the reference signal. Alternatively, the filtered signal is a first filtered signal and a second filtered signal derived from the input signal is provided as the reference signal.

It has to be understood that features, advantages and/or embodiments of the arc fault detection circuit as described in the above and in the following may be features of the method for detecting an arc fault as described in the above and in the following.

These and other aspects of the invention will be apparent from and elucidated with reference to the embodiments described hereinafter.

### BRIEF DESCRIPTION OF THE DRAWINGS

The subject matter of the invention will be explained in more detail in the following text with reference to exemplary embodiments which are illustrated in the attached drawings.
Fig. 1 schematically shows a block diagram of an arc fault detection circuit in accordance with one or more embodiments of the present invention;
Fig. 2 shows examples of magnitudes of a frequency response of two filters of an arc fault detection circuit in accordance with one or more embodiments of the present invention;
Fig. 3 shows examples of phases of a frequency response of two filters of an arc fault detection circuit in accordance with one or more embodiments of the present invention;
Fig. 4 schematically shows a block diagram of an arc fault detection circuit in accordance with one or more embodiments of the present invention;
Fig. 5 shows examples of magnitudes of a frequency response of two filters of an arc fault detection circuit in accordance with one or more embodiments of the present invention;
Fig. 6 schematically shows a block diagram of an arc fault detection circuit in accordance with one or more embodiments of the present invention;
Fig. 7 shows examples of magnitudes of a frequency response of two filters of the arc fault detection circuit of Fig. 6;
Fig. 8 schematically shows a block diagram of an arc fault detection circuit in accordance with one or more embodiments of the present invention;
Fig. 9 shows an output of a Schmitt trigger for two positions of a switch of an arc fault detection circuit in accordance with one or more embodiments of the present invention;
Fig. 10 shows a flowchart of an exemplary embodiment of a method for detecting an arc fault in an electric line in accordance with one or more embodiments of the present invention.

The reference symbols used in the drawings, and their meanings, are listed in summary form in the list of reference symbols. In principle, identical parts are provided with the same reference symbols in the figures.

### DETAILED DESCRIPTION OF EXEMPLARY EMBODIMENTS

An electrical network may comprise various electrical devices, i.e. loads. Alternatively or additionally, one or more electrical devices, i.e. loads, may be connected to the electrical network. At least some of the electrical devices may be connected via an electric line of the electrical network. If an arc fault is caused in the electrical network, a corresponding arc fault signal may be generated, which is transferred via the electric line. A typical arc fault signal may be present in a wide band of frequencies, e.g. ranging from 1 Hz to 1 GHz, e.g. from 10 Hz to 20 MHz.

In the same range, spectra of the loads in the electrical network may be found in a corresponding signal transferred via the electric line. If an energy of a signal of such a load is larger than that of an arc fault, masking of the corresponding arc fault signal may occur such that the arc fault may not be recognized or that the presence of an arc fault is determined, although there is no arc fault in the electrical network. In order to avoid such a mistake, the arc fault signals may be sensed in different frequency bands. The sensing of the arc fault in different frequency bands may be carried out by an arc fault detection circuit and/or by a method for detecting an arc fault as described in the following.

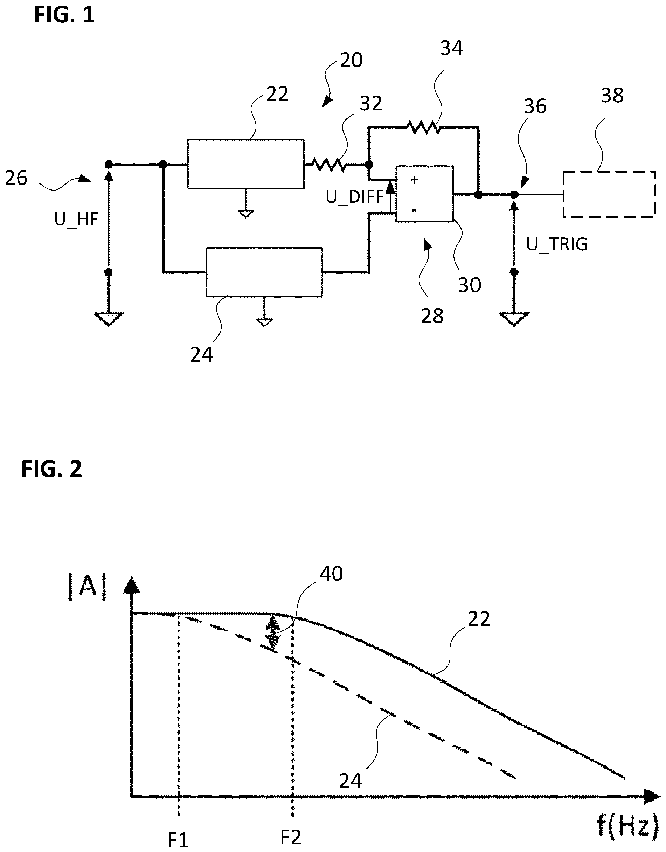

Fig. 1 schematically shows a block diagram of an arc fault detection circuit 20 in accordance with one or more embodiments of the present invention. The arc fault detection circuit 20 comprises a filter 22, e.g. a first low-pass filter, a circuit element, e.g. a second filter 24, e.g. a second low-pass filter, an input terminal 26, a Schmitt-trigger 28, an output terminal 36, and an arc fault determination module 38. The first filter 22 has a first cutoff frequency and, in case the circuit element is the second low-pass filter 24, the second filter 24 may have a second cutoff frequency, which is different from the first cutoff frequency. The Schmitt-trigger 28 may comprise a comparator 30, a first resistor 32, and a second resistor 34. The comparator 30 may be a comparator with hysteresis. As an alternative to the Schmitt-trigger 28 comprising the first resistor 32, the first filter 22 may comprise the first resistor 32. The first and second resistor 32, 34 determine the thresholds of the Schmitt-trigger 28. Alternatively, the threshold may be determined by an internal setting of the comparator. As an alternative to the second filter 24, the circuit element may be a voltage reference providing a constant DC-signal.

The input terminal 26 is coupled to the electric line of the electrical network (not shown), to a filter input of the filter 22, e.g. a first filter input of the first filter 22, and to a circuit element input of the circuit element, e.g. to a second filter input of the second filter 24. A first filter output of the first filter 22 is coupled to a first comparator input of the comparator 30 via the first resistor 32. The first filter output of the first filter 22 is also coupled to a comparator output of the comparator 30 via the first resistor 32 and the second resistor 34, which is arranged in series with the first resistor 32 and in parallel to the comparator 30. A circuit element output, e.g. a second filter output of the second filter 24, is coupled to a second comparator input of the comparator 30. The comparator output and the second resistor 34 are coupled to a terminal output 36, which is coupled to the arc fault determination module 38.

A signal transferred via the electric line of the electrical network may have an oscillating high frequency voltage U_HF, which is present at the terminal input 26, or may induce the oscillating high frequency voltage U_HF at the terminal input 26. The high frequency voltage U_HF may be referred to as input voltage U_HF or input signal. This input signal is transferred to the filter input of the filter 22, e.g. the first filter input of the first filter 22, and to the circuit element input of the circuit element, e.g. the second filter input of the second filter 24. The filter 22 provides a filtered signal at the filter output, e.g. a first filtered signal at the first filter output. The circuit element provides a reference signal at the circuit element output. The reference signal may be a signal providing a constant DC-value. Alternatively, if the circuit element is the second filter 24, the circuit element may provide a second filtered signal as the reference signal. If the circuit element is the second filter having a different cutoff frequency as the first filter, because of the difference between the first cutoff frequency of the first the filter 22 and the second cutoff frequency of the second filter 24, the first filtered signal is provided at the first filter output of the first filter 22 and the second filtered signal, which lies in a different frequency range as the first filtered signal, is provided at the second filter output of the second filter 24.

A differential voltage U_DIFF may be present between the first filtered signal at the first comparator input and the reference signal, e.g. the second filtered signal, at the second comparator input. If the differential voltage U_DIFF reaches one of the thresholds of the Schmitt-trigger 28, the binary output signal of the comparator 30, which is represented by an output voltage U TRIG, may change its state, i.e. from "1" to "0" or from "0" to " 1". In particular, the comparator 30 may be configured such that a first binary digit is provided at the comparator output, if the difference between the first filtered signal and the reference signal, e.g. the second filtered signal, is larger than a given first threshold, that a second binary digit, which is different from the first binary digit, is provided at the comparator output, if the difference between the first filtered signal and the second filtered signal is below a second threshold, which is smaller than the first threshold, and that the previously present binary digit is kept the same, if the difference is neither larger than first threshold nor smaller than the second threshold. The output voltage U_TRIG is applied to the arc fault determination module 38.

The arc fault determination module 38, or simply determination module, may correspond to one of the arc fault determination modules in accordance with the prior art described above. In particular, the arc fault determination module 38 may carry out a determination procedure, which corresponds to the determination procedure, which is carried out by the determination module of the above prior art, in order to determine whether one or more arc fault conditions are present in the electric line. In particular, the arc fault determination module may be configured to process one or more input values indicative of the operating conditions of the electric line to carry out arc fault detection functions. The arc detection functions may include real time detection algorithms to determine the possible presence of arc fault conditions in the electric line basing on the behaviour of some electric quantities (e.g. line currents and voltages) of the electric line. In general, however, the arc fault detection functions may be of known type and will not be described here in more detail for the sake of brevity.

Before the Schmitt-trigger 28, there may be a front-end of the arc fault detection circuit, e.g. a sensor, a transducer, and/or an amplifier, which introduces a global maximum of a power spectral density (PSD) of an arc fault signal, e.g. between 100 kHz and 20 MHz, e.g. between 5 MHz and 15 MHz, and attenuates the signal at lower frequencies (note that the PSD is relatively large at lower frequencies because the signature of the arc fault is proportional to 1/f). As a result, the output of the Schmitt-trigger 28 will toggle with an average frequency in that ranges. Nevertheless, non-negligible values of PSD at frequencies between 1 MHz and 10 MHz may be present. To capture the signals at frequencies away from these maxima, the filters 22, 24 are provided at each input of the Schmitt-trigger 28, i.e. the first resistor 32 and, respectively, the second comparator input.

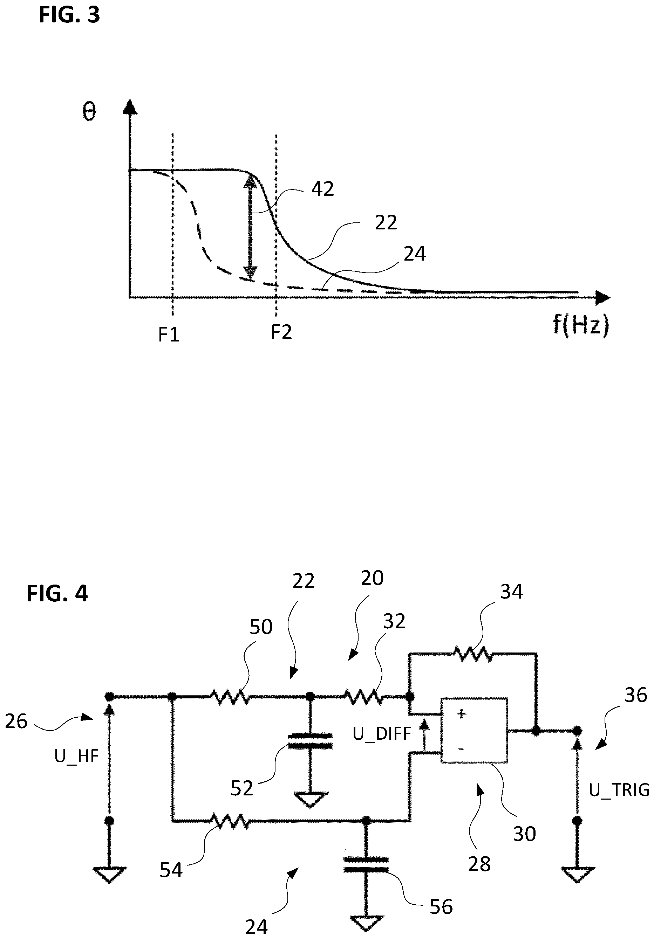

Fig. 2 shows examples of magnitudes of a frequency response of the two filters 22, 24 of the arc fault detection circuit 20 in accordance with one or more embodiments of the present invention. Fig. 3 shows examples of phases of a frequency response of the two filters 22, 24 of the arc fault detection circuit 20 in accordance with one or more embodiments of the present invention. So, in other words, figures 2 and 3 show an example of the frequency responses of the filters 22, 24, i.e. magnitudes and phases of the filters 22, 24, e.g. including a first frequency F 1 and a second frequency F2, at which the magnitudes start to decrease. One role of the first and second filters 22, 24 is to increase, e.g. maximize, the differential voltage U_DIFF for a desired frequency band. To achieve the desired values for the magnitude and phase response, it is advantageous to increase an amplitude difference 40 and a phase difference 42, wherein it may be maximally increased up to a phase angle of Pi.

Fig. 4 schematically shows a block diagram of an arc fault detection circuit 20 in accordance with one or more embodiments of the present invention. The arc fault detection circuit 20 may widely correspond to the above arc fault detection circuit 20 shown in figure 1.

The first filter 22 comprises a third resistor 50 and a first capacitor 52. If the circuit element is the second filter, the second filter 24 may comprise a fourth resistor 54 and a second capacitor 56. The third resistor 50 is connected in series with the first resistor 32. The first capacitor 52 is connected to a node between the third resistor 50 and the first resistor 32, and to ground. The fourth resistor 54 is connected in series between the input terminal 26 and the second comparator input of the comparator 30. The second capacitor 56 is connected to a node between the fourth resistor 54 and the second comparator input, and to ground. A resistance of the third resistor 50 is different from the resistance of the fourth resistor 54, and/or a capacitance of the first capacitor 52 is a different from a capacitance of the second capacitor 56. So, a frequency selectivity of the first filter 22 is different from a frequency selectivity of the second filter 24. The frequency selectivity of the first and/or second filter 22, 24 may be changed by changing the resistance of the third and/or, respectively, fourth resistor 50, 54, and/or by changing the capacitance of the first capacitor 52 and/or, respectively, the second capacitor 56.

So, in figure 4 an example of an implementation of the filters 22, 24 is given. The implementation consists of passive components only and contains least components. This passive implementation leads to a very simple configuration of the filters 22, 24. This simple configuration already yields a frequency selective behaviour.

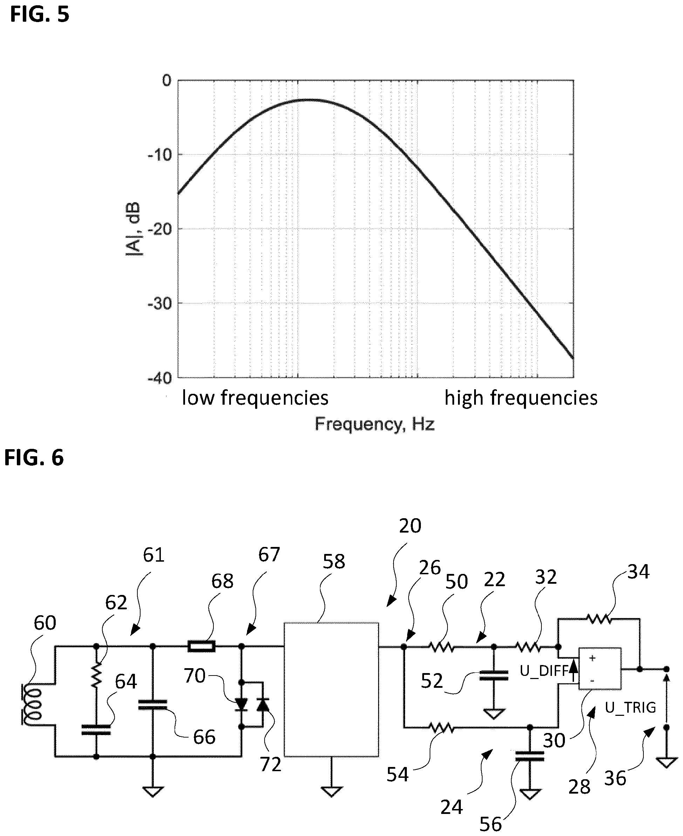

Fig. 5 shows examples of magnitudes of a frequency response of two filters of an arc fault detection circuit in accordance with one or more embodiments of the present invention.

In particular, figure 5 shows an extreme case where the capacitances of the first and second capacitors 52, 56 and the resistances of the third and fourth resistors 50, 54 are chosen such that the amplitude of filter's frequency response *H*(*jf*) = *U_DIFF*(*jf*)/*U_HF*(*jf*)) yields between 10 dB and 50 dB, e.g. between 25 dB and 35 dB suppression of the high frequencies (e.g. between 100 kHz and 20 MHz, e.g. between 5 MHz and 15 MHz) compared to the low frequencies (e.g. between 50 kHz and 500 kHz, e.g. between 100 kHz and 250 kHz). More complex implementations of the filters 22, 24 may yield a steeper transition and an even stronger attenuation outside the chosen frequency band.

Fig. 6 schematically shows a block diagram of an arc fault detection circuit 20 in accordance with one or more embodiments of the present invention. The arc fault detection circuit 20 may comprise the arc fault detection circuit 20 of figure 1 or figure 4.

In addition, the arc fault detection device 20 may comprise a filter stage 58, which is coupled to the input terminal 26, a coil 60, which is coupled to the electric line, an input filter 61, which is coupled to the coil 60 and which comprises a fifth resistor 62, a third capacitor 64, and a fourth capacitor 66, and a protection circuit 67, which may comprise a current limiting device 68, e.g. a resistor or a transient blocking unit, a first diode 70, and a second diode 72. The filter stage may be a band pass filter, a high-pass filter, or a Sallen-Key high-pass filter.

The coil 60 acts as a magnetic actuator, in particular a sensor for sensing the signal in the electric line. The coil 60 acts as a sensor for sensing the signal in the electric line. While the coil 60 is exemplified here, another electrical sensor such as one or more shunt resistors, Hall sensors, voltage dividers, and/or transformers can be used instead of the coil 60. The coil 60 may be electro-magnetically coupled to the electric line. For example, the coil 60 may be arranged such that a signal in the electric line induces a current in the windings of the coil 60. This current is representative for the signal in the electric line. The coil 60 may be a part of a current transformer used as a sensor for sensing the signal in the electric line.

The fifth resistor 62 and the third capacitor 64 of the input filter 61 are arranged in series, and parallel to the coil 60 of the input filter 61. The fourth capacitor 66 of the input filter 61 is arranged in parallel to the fifth resistor 62 and the third capacitor 64.

A current blocking device 68, e.g. a resistor or a transient blocking unit, of the protection circuit 67 is arranged and connected between the coil 60 and the filter stage 58. The first diode 70 of the protection circuit 67 is arranged in parallel to the second diode 72 of the protection circuit 67, wherein the diodes 72, 70 are arranged such that their forward current is opposite to each other. The diodes 70, 72 are arranged parallel to the fourth capacitor 66 of the input filter 61. The protection circuit 67 is connected to the filter stage 58.

The arc fault detection circuit 20 of figure 6 may be an analog front-end of an arc fault detection device further including the above determination module. The arc fault detection device may be referred to as electronic protection device for detecting an arc fault. The analogue front-end represents an example of an entire analog signal processing chain with the transducer, filters and the Schmitt-trigger 28.

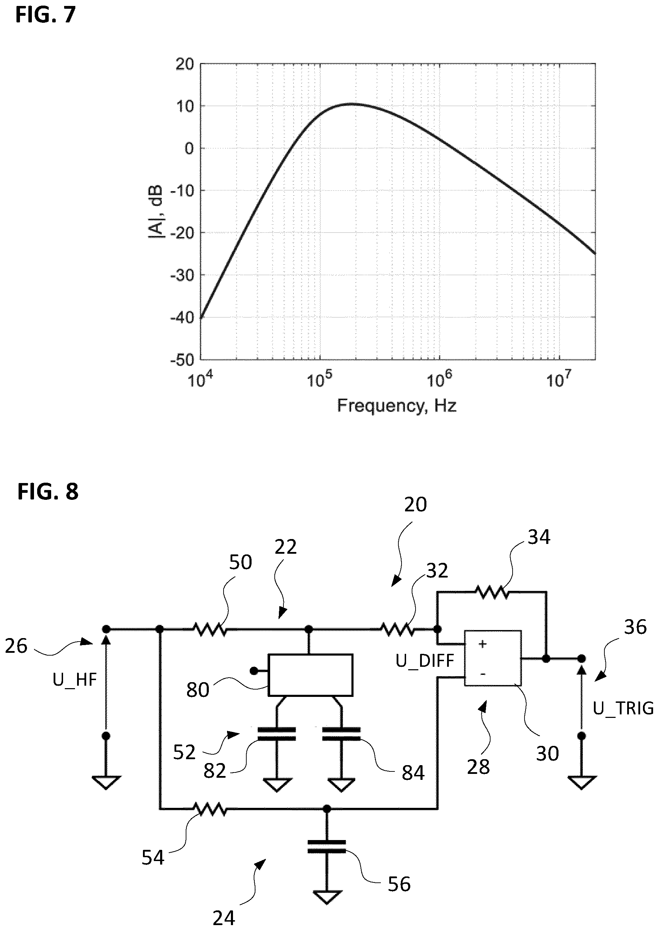

Fig. 7 shows magnitudes of a frequency response between the differential voltage U_DIFF at the input of the comparator 30 and the input voltage U_HF at the coil 60 of the arc fault detection circuit 20 of figure 6.

The filter stage 58 may be configured such that it amplifies all frequencies of interest, while the first and second filters 22, 24 at the input of the Schmitt-trigger 28 determine which frequencies will be attenuated.

Fig. 8 schematically shows a block diagram of an arc fault detection circuit 20 in accordance with one or more embodiments of the present invention. The arc fault detection circuit 20 may be a part of the analogue front-end of figure 6 and/or may widely correspond to one of the above arc fault detection circuits 20. In particular, figure 8 shows one potential implementation of the first filter 22 having a programmable frequency characteristic. To this end, at least one of the filters 22, 24 may comprise a first filter element providing a first frequency selectivity, a second filter element comprising a second frequency selectivity, and a switchable component for switching between the first and second filter element.

For example, the first filter 22 comprises a switch 80 as the switchable component, a sixth capacitor 82 as the first filter element and a seventh capacitor 84 as the second filter element. A capacitance of the sixth capacitor 82 is different from a capacitance of the seventh capacitor 84. The switch 80 may be an analogue and/or mechanical switch. Alternatively, the switch 80 may be transistor. The switch may be coupled to and actuated by a control unit (not shown) of the arc fault detection device, e.g. of the determination module. In one state of the switch 80 the sixth capacitor 82 is connected to the Schmitt-trigger 28 and in the other state the seventh capacitor 84 is connected to the Schmitt-trigger 28. The switching between the two states of the switch 80 changes the frequency selectivity of the first filter 22.

Figure 8 shows the switch 80 as being integrated into the first filter 22. Alternatively, the switch 80 may be integrated into the second filter 24. Alternatively, there may be an additional switch (not shown) in the second filter 24. As a further alternative, one or two corresponding switches (not shown) may be connected to the filter inputs of the first and, respectively second filters 22, 24.

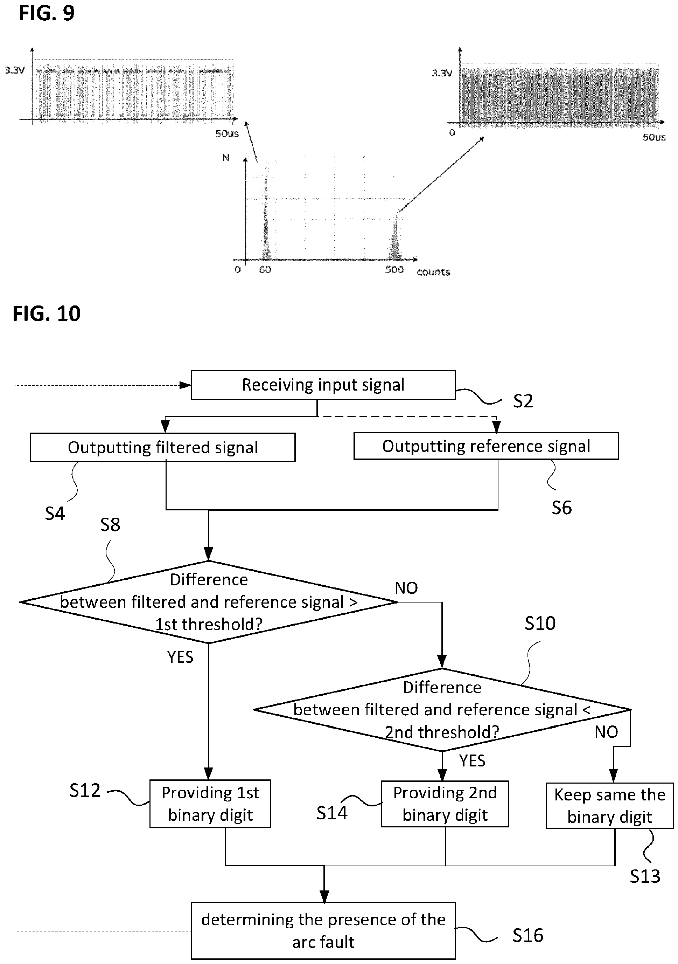

Fig. 9 shows an output of a Schmitt trigger for two positions of a switch of an arc fault detection circuit in accordance with one or more embodiments of the present invention. A first diagram is shown in the middle of figure 9, a second diagram is shown above the first diagram on the left side of figure 9, and a third diagram is shown above the first diagram on the right side of figure 9.

In particular, figure 9 shows the output voltage U_TRIG of the Schmitt-trigger 28 for the two states of the switch 80 of the frequency selective arc fault detection circuit 20. The arc fault detection circuit 20 may be implemented in the arc fault detection device, e.g. as described in the above-mentioned prior art.

To test the arc fault detection circuit 20 a synthetic arc fault signal (e.g. a corresponding current) was fed into the sensing element, e.g. the coil 60, and the output voltage U_TRIG of the Schmitt-trigger 28 was measured. The power spectral density of the synthetic arc fault signal determines which frequency dominates the toggling of the Schmitt -trigger 28. The results shown in figure 9 are qualitative and only used to demonstrate the switching between two frequency bands.

The graphs shown in figure 9 are the results of two distinct tests, performed during two distinct intervals of the same duration. The first test was performed at the lower frequencies (see upper left diagram) and resulted in 60 counts (see the lower diagram). The second test was performed at the higher frequencies and resulted into 500 counts (see upper left diagram and left peak in the lower diagram). The lower diagram of figure 9 shows the number of the rising edges (referred to as "counts") in the upper diagrams within the corresponding duration, e.g. a 50 µs. For the tests in the two frequency bands, a control unit, e.g. a microcontroller of the arc fault detection device, was configured to change the state of the switch 80 every 2 seconds, i.e. to change the frequency selectivity of the Schmitt-trigger 28 every 2 seconds. The signal has been acquired for several minutes and the histogram of counts, i.e. the lower diagram, has been constructed. In the result, two significant groups of counts, around 60 and around 500, have been observed. Since these counts have been acquired during the same duration it can be said that the first group of counts comes from the lower frequency band whereas the second group comes from the higher frequency band.

Fig. 10 shows a flowchart of an exemplary embodiment of a method for detecting an arc fault in an electric line in accordance with one or more embodiments of the present invention. The method may be carried out by an electronic detection device and/or by an arc fault detection device each comprising one of the above arc fault detection circuits 20.

In a step S2, an input signal from an electric line of an electrical network is received, e.g. by the coil 60 and/or at the input terminal 26. The input signal is supplied to the first filter 22 and, in case the circuit element is the second filter 24, to the second filter 24.

In a step S4, a filtered signal, e.g. the first filtered signal, is output, e.g. by the first filter 22. The filtered signal is supplied to the first comparator input of the comparator 30, optionally via the first resistor 32.

In a step S6, a reference signal, e.g. the second filtered signal, is output by the circuit element, e.g. by the second filter 24. The reference signal is supplied to the second comparator input of the comparator 30.

In a step S8, it is determined, whether a difference between the filtered signal and the reference signal, e.g. the differential voltage U _DIFF, is larger than a given first threshold. If the difference is not larger than the given first threshold, the method proceeds with a step S10. If the difference is larger than the given first threshold, the method proceeds with a step S12.

In step S10, it is determined, whether the difference is smaller than a given second threshold, which is smaller than the first threshold. If the difference is smaller than the given second threshold, the method proceeds with a step S14. If the difference is neither larger than the first threshold nor smaller than the second threshold, the method proceeds with a step S13.

In step S12, a first binary digit, e.g. "1", is provided at the terminal output 36, e.g. as a part of the output voltage U_TRIG of the Schmitt-trigger 28.

In step S13, the same binary digit, which is already provided at the terminal output 36, is kept.

In step S14, a second binary digit, e.g. "0", is provided at the terminal output 36, e.g. as a part of the output voltage U_TRIG of the Schmitt-trigger 28.

In step S16, the presence of the arc fault is determined from the output voltage U_TRIG of the Schmitt-trigger 28, e.g. by the above determination module.

The method may be constantly and/or repeatedly carried out as long as there are active loads in the electrical network. Further, the frequency selectivity of the first and/or the second low-pass filters 22, 24 may be changed several times each time the method is carried out.

The method may be provided as a machine-readable code comprising instructions, which may be carried out by a control unit, e.g. the above-mentioned control unit. The machine-readable code may be provided on a computer-readable medium. The computer-readable medium may be a floppy disk, a hard disk, an USB (Universal Serial Bus) storage device, a RAM (Random Access Memory), a ROM (Read Only Memory), an EPROM (Erasable Programmable Read Only Memory) or a FLASH memory. A computer readable medium may also be a data communication network, e.g. the Internet, which allows downloading a program code. In general, the computer-readable medium may be a non-transitory or transitory medium.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

### LIST OF REFERENCE SYMBOLS

- 20: arc fault detection circuit
- 22: first filter
- 24: second filter
- 26: input terminal
- 28: Schmitt-Trigger
- 30: comparator
- 32: first resistor
- 34: second resistor
- 36: output terminal
- 38: arc fault determination module
- 40: first difference
- 42: second difference
- 50: third resistor
- 52: first capacitor
- 54: fourth resistor
- 56: second capacitor
- 58: filter stage
- 60: coil
- 61: input filter
- 62: fifth resistor
- 64: third capacitor
- 66: fourth capacitor
- 67: protection circuit
- 68: current blocking device
- 70: first diode
- 72: second diode
- 80: switch
- 82: sixth capacitor
- 84: seventh capacitor
- S2 - S16: steps two to sixteen
- U_HF: high frequency voltage
- H_DIFF: differential voltage
- U_TRIG: output voltage
- F1: first frequency
- F2: second frequency

## Claims

1. Arc fault detection circuit (20) for detecting an arc fault in an electric line, comprising:
a filter (22), which has a filter input for receiving an input signal from the electric line and a filter output for outputting a filtered signal;
a circuit element for outputting a reference signal;
a comparator (30), which has a first comparator input coupled to the filter output for receiving the filtered signal, a second comparator input coupled to the circuit element output for receiving the reference signal, and a comparator output for providing a binary output signal depending on a difference between the filtered signal and the reference signal; and
an arc fault determination module (38), which is coupled to the comparator output and which is configured to determine the presence of the arc fault in the electric line depending on the output signals of the comparator (30),
**characterised in that**
the filter (22) is configured such that a cutoff frequency of the filter (22) can be changed.

2. Arc fault detection circuit (20) in accordance with claim 1,
wherein the circuit element provides a constant DC-value as the reference signal.

3. Arc fault detection circuit (20) in accordance with claim 1,
wherein the filter (22) is a first filter, the filter input is a first filter input for receiving the input signal from the electric line, the filter output is a first filter output, and the filtered signal is a first filtered signal; and
wherein the circuit element comprises a second filter (24) having a second filter input for receiving the input signal from the electric line and a second filter output for outputting a second filtered signal as the reference signal.

4. Arc fault detection circuit (20) in accordance with claim 3,
wherein the second filter (24) is configured such that a cutoff frequency of the second filter (24) can be changed.

5. Arc fault detection circuit (20) in accordance with one of the preceding claims,
wherein the filter of the filters (22, 24), which is configured such that its cutoff frequency can be changed, comprises a first filter element (82) providing a first cutoff frequency and a second filter element (84) providing a second cutoff frequency, and wherein the cutoff frequency of the corresponding filter (22, 24) can be changed by activating the first filter element (82) or the second filter element (84).

6. Arc fault detection circuit (20) in accordance with claim 5,
wherein the first filter element (82) comprises a first capacitor, which has a first capacitance, and the second filter element (84) comprises a second capacitor, which has a second capacitance different from the first capacitance.

7. Arc fault detection circuit (20) in accordance with one of the preceding claims,
wherein at least one of the filters (22, 24) is a passive filter; and/or
wherein at least one of the filters (22, 24) comprises an inductor and/or a capacitor (82, 84).

8. Arc fault detection circuit (20) in accordance with one of claims 5 to 7, further comprising:
a switch (80) for activating the first filter element (82) or the second filter element (84).

9. Arc fault detection circuit (20) in accordance with claim 8,
wherein the switch (80) is an analogue and/or mechanical switch.

10. Arc fault detection circuit (20) in accordance with one of the preceding claims,
wherein the comparator (30) is a comparator with hysteresis.

11. Arc fault detection circuit (20) in accordance with one of the preceding claims,
wherein the comparator (30) is an analogue comparator.

12. Arc fault detection circuit (20) in accordance with one of the preceding claims, further comprising a Schmitt-Trigger (28), which comprises the comparator (30).

13. Arc fault detection circuit (20) in accordance with one of the preceding claims, further comprising:
a coil (60), which is coupled to the electric line and which serves as a sensor;
an input filter (61), which is coupled to the coil (60);
a protection circuit (67), which is coupled to the input filter; and
a filter stage (58), which is coupled to the protection circuit (67), the filter input of the filter (22), and the circuit element input of the circuit element for providing the input signal to the filter (22) and, respectively, the circuit element.

14. Method for detecting an arc fault in an electric line, comprising:
receiving an input signal from the electric line and outputting a filtered signal, by a filter (22);
outputting a reference signal, by a circuit element;
providing a binary output signal depending on a difference between the filtered signal and the reference signal; and
determining the presence of the arc fault in the electric line depending on the output signals,
**characterised in that**
a cutoff frequency of the filter (22) can be changed.

15. Method in accordance with claim 14,
wherein a constant DC-value is provided as the reference signal, or
wherein the filtered signal is a first filtered signal and a second filtered signal derived from the input signal is provided as the reference signal.

## Patentansprüche

1. Lichtbogenfehlerdetektionsschaltung (20) zum Detektieren eines Lichtbogenfehlers in einer elektrischen Leitung, umfassend:
ein Filter (22), das einen Filtereingang zum Empfangen eines Eingangssignals von der elektrischen Leitung und einen Filterausgang zum Ausgeben eines gefilterten Signals aufweist;
ein Schaltungselement zum Ausgeben eines Referenzsignals;
einen Komparator (30), der einen ersten Komparatoreingang, der mit dem Filterausgang zum Empfangen des gefilterten Signals gekoppelt ist, einen zweiten Komparatoreingang, der mit dem Schaltungselementausgang zum Empfangen des Referenzsignals gekoppelt ist, und einen Komparatorausgang zum Bereitstellen eines binären Ausgangssignals in Abhängigkeit von einer Differenz zwischen dem gefilterten Signal und dem Referenzsignal aufweist; und
ein Lichtbogenfehlerbestimmungsmodul (38), das mit dem Komparatorausgang gekoppelt ist und das dazu ausgelegt ist, das Vorhandensein des Lichtbogenfehlers in der elektrischen Leitung in Abhängigkeit von den Ausgangssignalen des Komparators (30) zu bestimmen,
**dadurch gekennzeichnet, dass** das Filter (22) so ausgelegt ist, dass eine Grenzfrequenz des Filters (22) geändert werden kann.

2. Lichtbogenfehlerdetektionsschaltung (20) nach Anspruch 1,
wobei das Schaltungselement einen konstanten Gleichstromwert als Referenzsignal bereitstellt.

3. Lichtbogenfehlerdetektionsschaltung (20) nach Anspruch 1,
wobei das Filter (22) ein erstes Filter ist, der Filtereingang ein erster Filtereingang zum Empfangen des Eingangssignals von der elektrischen Leitung ist, der Filterausgang ein erster Filterausgang ist und das gefilterte Signal ein erstes gefiltertes Signal ist; und wobei das Schaltungselement ein zweites Filter (24) mit einem zweiten Filtereingang zum Empfangen des Eingangssignals von der elektrischen Leitung und einem zweiten Filterausgang zum Ausgeben eines zweiten gefilterten Signals als das Referenzsignal aufweist.

4. Lichtbogenfehlerdetektionsschaltung (20) nach Anspruch 3,
wobei das zweite Filter (24) so ausgelegt ist, dass eine Grenzfrequenz des zweiten Filters (24) geändert werden kann.

5. Lichtbogenfehlerdetektionsschaltung (20) nach einem der vorhergehenden Ansprüche,
wobei das Filter der Filter (22, 24), das so ausgelegt ist, dass seine Grenzfrequenz geändert werden kann, ein erstes Filterelement (82), das eine erste Grenzfrequenz bereitstellt, und ein zweites Filterelement (84), das eine zweite Grenzfrequenz bereitstellt, umfasst, und wobei die Grenzfrequenz des entsprechenden Filters (22, 24) durch Aktivieren des ersten Filterelements (82) oder des zweiten Filterelements (84) geändert werden kann.

6. Lichtbogenfehlerdetektionsschaltung (20) nach Anspruch 5,
wobei das erste Filterelement (82) einen ersten Kondensator umfasst, der eine erste Kapazität aufweist, und das zweite Filterelement (84) einen zweiten Kondensator umfasst, der eine zweite Kapazität aufweist, die sich von der ersten Kapazität unterscheidet.

7. Lichtbogenfehlerdetektionsschaltung (20) nach einem der vorhergehenden Ansprüche,
wobei mindestens eines der Filter (22, 24) ein passives Filter ist; und/oder
wobei mindestens eines der Filter (22, 24) eine Induktivität und/oder einen Kondensator (82, 84) umfasst.

8. Lichtbogenfehlerdetektionsschaltung (20) nach einem der Ansprüche 5 bis 7, die ferner umfasst:
einen Schalter (80) zum Aktivieren des ersten Filterelements (82) oder des zweiten Filterelements (84).

9. Lichtbogenfehlerdetektionsschaltung (20) nach Anspruch 8,
wobei der Schalter (80) ein analoger und/oder mechanischer Schalter ist.

10. Lichtbogenfehlerdetektionsschaltung (20) nach einem der vorhergehenden Ansprüche,
wobei der Komparator (30) ein Komparator mit Hysterese ist.

11. Lichtbogenfehlerdetektionsschaltung (20) nach einem der vorhergehenden Ansprüche,
wobei der Komparator (30) ein analoger Komparator ist.

12. Lichtbogenfehlerdetektionsschaltung (20) nach einem der vorhergehenden Ansprüche, die ferner einen Schmitt-Trigger (28) umfasst, der den Komparator (30) umfasst.

13. Lichtbogenfehlerdetektionsschaltung (20) nach einem der vorhergehenden Ansprüche, die ferner umfasst:
eine Spule (60), die mit der elektrischen Leitung gekoppelt ist und als Sensor dient;
ein Eingangsfilter (61), das mit der Spule (60) gekoppelt ist;
eine Schutzschaltung (67), die mit dem Eingangsfilter gekoppelt ist; und
eine Filterstufe (58), die mit der Schutzschaltung (67), dem Filtereingang des Filters (22) und dem Schaltungselementeingang des Schaltungselements gekoppelt ist, um das Eingangssignal für das Filter (22) bzw. das Schaltungselement bereitzustellen.

14. Verfahren zum Detektieren eines Lichtbogenfehlers in einer elektrischen Leitung, das umfasst:
Empfangen eines Eingangssignals von der elektrischen Leitung und Ausgeben eines gefilterten Signals durch ein Filter (22);
Ausgeben eines Referenzsignals durch ein Schaltungselement;
Bereitstellen eines binären Ausgangssignals in Abhängigkeit von einer Differenz zwischen dem gefilterten Signal und dem Referenzsignal; und
Bestimmen des Vorhandenseins des Lichtbogens in der elektrischen Leitung in Abhängigkeit von den Ausgangssignalen,
**dadurch gekennzeichnet, dass** eine Grenzfrequenz des Filters (22) geändert werden kann.

15. Verfahren nach Anspruch 14,
wobei ein konstanter Gleichstromwert als Referenzsignal bereitgestellt wird, oder
wobei das gefilterte Signal ein erstes gefiltertes Signal ist und ein zweites gefiltertes Signal, das von dem Eingangssignal abgeleitet ist, als Referenzsignal bereitgestellt wird.

## Revendications

1. Circuit de détection de défaut d'arc (20) pour détecter un défaut d'arc dans une ligne électrique, le circuit comprenant :
un filtre (22), qui a une entrée de filtre pour recevoir un signal d'entrée de la ligne électrique et une sortie de filtre pour délivrer en sortie un signal filtré ;
un élément de circuit pour délivrer en sortie un signal de référence ;
un comparateur (30), qui possède une première entrée de comparateur couplée à la sortie du filtre pour recevoir le signal filtré, une deuxième entrée de comparateur couplée à la sortie de l'élément de circuit pour recevoir le signal de référence, et une sortie de comparateur pour fournir un signal de sortie binaire en fonction d'une différence entre le signal filtré et le signal de référence ; et
un module de détermination de défaut d'arc (38), couplé à la sortie du comparateur et configuré pour déterminer la présence d'un défaut d'arc dans la ligne électrique en fonction des signaux de sortie du comparateur (30),
**caractérisé en ce que** le filtre (22) est configuré de manière à ce qu'une fréquence de coupure du filtre (22) puisse être modifiée.

2. Circuit de détection de défaut d'arc (20) selon la revendication 1,
dans lequel l'élément de circuit fournit une valeur continue constante comme signal de référence.

3. Circuit de détection de défaut d'arc (20) selon la revendication 1,
dans lequel le filtre (22) est un premier filtre, l'entrée du filtre est une première entrée de filtre pour recevoir le signal d'entrée de la ligne électrique, la sortie du filtre est une première sortie de filtre, et le signal filtré est un premier signal filtré ; et
dans lequel l'élément de circuit comprend un deuxième filtre (24) ayant une deuxième entrée de filtre pour recevoir le signal d'entrée de la ligne électrique et une deuxième sortie de filtre pour délivrer en sortie un deuxième signal filtré en tant que signal de référence.

4. Circuit de détection de défaut d'arc (20) selon la revendication 3,
dans lequel le deuxième filtre (24) est configuré de telle sorte qu'une fréquence de coupure du deuxième filtre (24) peut être modifiée.

5. Circuit de détection de défaut d'arc (20) selon l'une des revendications précédentes,
dans lequel le filtre des filtres (22, 24), qui est configuré de manière à ce que sa fréquence de coupure puisse être modifiée, comprend un premier élément filtrant (82) fournissant une première fréquence de coupure et un deuxième élément filtrant (84) fournissant une deuxième fréquence de coupure, et dans lequel la fréquence de coupure du filtre correspondant (22, 24) peut être modifiée en activant le premier élément filtrant (82) ou le deuxième élément filtrant (84).

6. Circuit de détection de défaut d'arc (20) selon la revendication 5,
dans lequel le premier élément filtrant (82) comprend un premier condensateur, qui a une première capacité, et le deuxième élément filtrant (84) comprend un deuxième condensateur, qui a une deuxième capacité différente de la première capacité.

7. Circuit de détection de défaut d'arc (20) selon l'une des revendications précédentes,
dans lequel au moins un des filtres (22, 24) est un filtre passif ; et/ou
dans lequel au moins un des filtres (22, 24) comprend un inducteur et/ou un condensateur (82, 84).

8. Circuit de détection de défaut d'arc (20) selon l'une des revendications 5 à 7, comprenant en outre :
un interrupteur (80) pour activer le premier élément filtrant (82) ou le deuxième élément filtrant (84).

9. Circuit de détection de défaut d'arc (20) selon la revendication 8,
dans lequel l'interrupteur (80) est un interrupteur analogique et/ou mécanique.

10. Circuit de détection de défaut d'arc (20) selon l'une des revendications précédentes,
dans lequel le comparateur (30) est un comparateur à hystérésis.

11. Circuit de détection de défaut d'arc (20) selon l'une des revendications précédentes,
dans lequel le comparateur (30) est un comparateur analogique.

12. Circuit de détection de défaut d'arc (20) selon l'une des revendications précédentes, comprenant en outre un déclencheur de Schmitt (28), qui comprend le comparateur (30).

13. Circuit de détection de défaut d'arc (20) selon l'une des revendications précédentes, comprenant en outre :
une bobine (60), qui est couplée à la ligne électrique et qui sert de capteur ;
un filtre d'entrée (61), qui est couplé à la bobine (60) ; un circuit de protection (67), qui est couplé au filtre d'entrée ; et
un étage de filtrage (58), couplé au circuit de protection (67), à l'entrée du filtre (22) et à l'entrée de l'élément de circuit de l'élément de circuit destiné à fournir le signal d'entrée au filtre (22) et, respectivement, à l'élément de circuit.

14. Procédé de détection d'un défaut d'arc dans une ligne électrique, le procédé comprenant les étapes suivantes :
recevoir un signal d'entrée en provenance de la ligne électrique et délivrer en sortie un signal filtré par un filtre (22) ;
délivrer en sortie un signal de référence par un élément de circuit ;
fournir un signal de sortie binaire en fonction de la différence entre le signal filtré et le signal de référence ; et
déterminer la présence d'un défaut d'arc dans la ligne électrique en fonction des signaux de sortie,
**caractérisé en ce qu'**une fréquence de coupure du filtre (22) peut être modifiée.

15. Procédé selon la revendication 14,
dans lequel une valeur continue constante est fournie comme signal de référence, ou
dans lequel le signal filtré est un premier signal filtré et un deuxième signal filtré dérivé du signal d'entrée est fourni comme signal de référence.
